# EUROPEAN PATENT APPLICATION

(11) **EP 4 697 381 A1**
(43) Date of publication of application: **18.02.2026**
(21) Application number: 24194368.7
(22) Date of filing: 13.08.2024
(51) Int. Cl.: H01L 23/367, H01L 23/427

(54) **HEATSINK FOR A POWER SEMICONDUCTOR DEVICE OF AN INVERTER SYSTEM OF AN ELECTRIC VEHICLE**

(71) Applicant: Volvo Car Corporation, 405 31 Göteborg (SE)
(72) Inventor: ZHANG, Chi, 40531 Göteborg (SE)
(74) Representative: Maiwald GmbH

(57) **Abstract**

The disclosure relates to a heatsink (20) for a power semiconductor device (11) of an inverter system of an electric vehicle, the heatsink (20) comprising a body for heat exchange with one or more semiconductor chips (11) of the power semiconductor device (10), the body comprising a base portion (21) for attachment to the power semiconductor device (10) and a fin portion (23) adjacent to the base portion (21), the fin portion (23) comprising a plurality of fins extended from the base portion (21), and the heatsink (20) comprising one or more interior channels for cooling the heatsink (20), the one or more interior channels extending inside the body.

## Description

### TECHNICAL FIELD

The present disclosure relates to a heatsink for a power semiconductor device of an inverter system of an electric car, a power semiconductor device, and an electric vehicle.

### BACKGROUND ART

Power semiconductor devices in inverter systems face significant challenges related to heat dissipation and power loss. One common solution to mitigate these issues involves the use of heatsinks attached to the power semiconductor devices, which helps prevent potential damage of the power semiconductors devices caused by overheating.

While the heatsink attached to the power semiconductor devices cools the semiconductor chip of the power semiconductor device, it necessitates an additional mechanism to cool the heatsink externally. This requirement results in larger sizes of the power semiconductor devices and complicates the cooling process, reducing efficiency.

### SUMMARY

The problem is at least partially solved or alleviated by the subject matter of the independent claims of the present disclosure, wherein further examples are incorporated in the dependent claims.

According to a first aspect, there may be provided a heatsink for a power semiconductor device of an inverter system of an electric vehicle, the heatsink comprising a body for heat exchange with one or more semiconductor chips of the power semiconductor device, the body comprising a base portion for attachment to the power semiconductor device and a fin portion adjacent to the base portion, the fin portion comprising a plurality of fins extended from the base portion, and the heatsink comprising one or more interior channels for cooling the heatsink, the one or more interior channels extending inside the body.

### SE:AFE:MSE

The heatsink in the power semiconductor device may attach to the one or more power semiconductor chips to transfer the heat generated by the one or more semiconductor chips to a surrounding environment. The heatsink may comprise one or more interior channels to enhance heat transfer from one or more semiconductor chips to the surrounding environment. In other words, these interior channels, extending inside the body of the heatsink, may be implemented to improve the cooling efficiency of the power semiconductor device. The one or more interior channels may for example but not only be extending straight, meandering, or braided inside the body. The one or more interior channels may for example be extended along the length, width, or height of the body. For example, there may be two or more interior channels connected to one another, thereby enhancing the heat transfer. More cooling capacity for cooling the one or more semiconductor chips may be provided inside the heatsink with the one or more interior channels extending inside the body. Accordingly, the invention solves the above-mentioned problem in the cooling process of the power semiconductor devices of an inverter system by providing one or more interior channels for cooling the heatsink, the one or more interior channels extending inside the body. The invention thereby may improve the efficiency of heat transfer between the one or more power semiconductor chips and the heatsink.

Generally, a heatsink may be a device that transfers heat from an electronic device, a mechanical device, or a process to a fluid medium. The fluid medium may be surrounding the heatsink and it may be a liquid coolant or air, for example. The body of the heatsink may be made from a heat-conducting material, such as a metal, particularly aluminum or copper. The body of the heatsink may comprise at least a base portion and a fin portion and may be of one-piece construction. In other words, the base portion and the fin portion are made from the same material and manufactured as a single, continuous part without any separate joints or connections. The base portion may be thermally connected to the parts of the device which are generating the heat, specifically the one or more semiconductor chips. The fin portion comprises a plurality of fins, which may be designed to maximize the surface area in contact with a fluid medium surrounding the fin portion. The plurality of fins may be in the form of pins, or pin fins, which extend from the base portion, allowing the fluid medium to flow between them and/or may be cylindrical, elliptical, or square in shape. The pin fins may for example be in the form of splayed fins, where the fins are angled or bent outward from the base portion. Alternatively, the plurality of fins may be in the form of plate fins, which are flat, thin structures attached to the base portion and extend from it. Additionally, the plurality of fins may be in the form of flexible fins, which are adjustable and can bend or move slightly to adapt to variations in fluid medium flow or mechanical stress. The heat transfer between the fin portion and the fluid medium may be a natural convection process, which requires free flow of the fluid medium over the body of the heatsink, and/or it may be an active convection process using a cooling device to flow the fluid medium over the body of the heatsink. Other words for heatsink may be radiator or heat dissipator.

Generally, a power semiconductor device may be an electronic device that controls and manages the flow of electrical power in circuits. It may be capable of handling high voltages and currents and may be used in applications such as power conversion, regulation, and switching. The power semiconductor device may be of any type, including but not limited to inverter systems, converter systems and similar. That the heatsink is for a power semiconductor device of an inverter system of an electric vehicle merely indicates the suitability for such device and not a limitation towards such device. The power semiconductor device may be used for any type of application, including but not limited to electric vehicles. An electric vehicle is any vehicle that has an electric motor in its drive system and includes, for example, hybrid electric vehicles and fuel cell vehicles. Further, generally, the vehicle may be of any type, including but not limited to cars, trucks, and similar.

Thermal coupling may be used where two or more components or systems are connected in such a way that heat can be transferred between them. In other words, changing temperature of one of the components may cause changing temperature of the other components. There may be different ways for thermal coupling comprising conduction, which is direct heat transfer through a solid material connecting the components, convection, which is indirect heat transfer between the components through a fluid flowing between the components, or radiation, which is heat transfer through electromagnetic waves between the components.

In an example, the one or more interior channels may be at least partially filled with a phase change material.

Generally, the phase change material, PCM, may be a substance that absorbs and releases heat during its phase transition between solid and liquid states, such as during melting or solidifying. PCM may also release heat during its phase transition between liquid and gas states. PCMs may have a phase change temperature at which they change from one phase to another. As PCMs absorb heat, their temperature may increase. When PCMs reach their phase change temperature, also known as their melting point, they may absorb a significant amount of heat at a nearly constant temperature until all the material has melted. This characteristic of PCMs may allow them to absorb significantly more heat compared to non-phase change materials. Accordingly, the one or more interior channels at least partially filled with the PCM may absorb significantly more heat from the one or more power semiconductor chips compared to a solution with a natural or active convection process at the fin portion. More cooling capacity for cooling the one or more semiconductor chips may be provided inside the heatsink with the one or more interior channels extending inside the body, filled at least partially with the PMC. The PCM may for example include organic material like hydrocarbon, or inorganic material such as salt hydrate or hygroscopic substance. "At least partially filled" means that the one or more interior channels may not be completely empty but contain at least some amount of phase change material, or they may be completely filled with it.

In an example, the body may comprise an inlet and an outlet, the inlet and outlet being fluidically coupled to the one or more interior channels for passing a cooling fluid through the one or more interior channels.

The cooling fluid flowing between the inlet and the outlet of the heatsink body may pass through the one or more interior channels. As a result, these interior channels may be cooled by the passing cooling fluid. Accordingly, the heat transfer from the one or more power semiconductor chips to the heatsink may be enhanced. The inlet may receive the cooling fluid, guiding it into the body, particularly into the one or more interior channels. The outlet may expel the cooling fluid the body, particularly from the one or more interior channels. The inlet may comprise one or more inlet ports, and the outlet may comprise one or more outlet ports. The inlet and outlet can be arranged on the same side of the body, on opposite sides, or in various other configurations.

In an example, at least one of the one or more interior channels may extend inside the plurality of fins.

The one or more interior channels extending inside the body may also extend inside the fin portion. In particular, the one or more interior channels may extend within the plurality of fins. The one or more interior channels within the plurality of fins may be arranged transversely to the base portion. More cooling capacity for cooling the one or more semiconductor chips may be provided inside the heatsink with the one or more interior channels extending inside the plurality of fins. Consequently, the heat transfer between the base portion and the fin portion may be improved.

In an example, the at least one interior channel may extend in a meandering shape between adjacent fins of the plurality of fins.

The meandering shape between adjacent fins of the plurality of fins may be provided as a winding, curving, or serpentine path. The at least one interior channel extending in a meandering shape may not follow a straight line but instead take a circuitous route between the adjacent fins of the plurality of fins. The at least one interior channel extending in a meandering shape may be connected to the one or more interior channels extending inside the body. The meandering shape of the at least one interior channel between adjacent fins may increase the surface area of the channel. The at least one interior channel extending in a meandering shape may enhance a flowing path for passing the cooling fluid. Consequently, the cooling fluid may flow smoothly between the adjacent fins of the plurality of fins. Thus, more cooling capacity for cooling the one or more semiconductor chips may be provided.

In an example, the at least one of the one or more interior channels may extend inside the base portion.

The one or more interior channels extending inside the body may also extend inside the base portion and/or inside the fin portion. The one or more interior channels extended inside the plurality of fins may be arranged transversely to those channels extending inside the base portion. Consequently, heat transfer between the base portion and the fin portion may be improved. The cooling fluid may pass through the one or more interior channels extending inside the base portion and one or more interior channels extending inside the fin portion. Thus, more cooling capacity for cooling the one or more semiconductor chips may be provided inside the heatsink with the one or more interior channels extending inside the plurality of fins as well as inside the base portion.

In an example, the adjacent fins of the plurality of fins may be spaced apart from one another in a direction transverse to their extension for convection cooling of the body.

The adjacent fins of the plurality of fins may be arranged to be spaced apart from one another in a direction substantially transverse or orthogonal to the extension direction of the fins. The term "their extension" may be used for the direction along a height of each individual fin of the heatsink. The spacing between the adjacent fins of the plurality of fins may be arranged in a direction that is substantially transverse or orthogonal to the direction along the height of the fins. In other words, the fins extend along their height from the base portion, and the spacing between each adjacent fin may be determined in a direction that is transverse to the heightwise extension of the fins. This transverse spacing between the adjacent fins may ensure more cooling capacity for cooling the one or more semiconductor chips. Furthermore, the transverse spacing between the adjacent fins may allow cooling fluid to flow between the fins and carry away heat effectively. Thus, said configuration may ensure that the adjacent fins are arranged in such a way that the space between them is aligned in a direction that crosses or is at a right angle to their elongated direction, maximizing convection cooling performance of the heatsink.

According to a second aspect, there may be provided a power semiconductor device for an inverter system of an electric vehicle, the power semiconductor device comprising one or more semiconductor chips and one or more heatsinks of the first aspect, wherein the one or more heatsinks is thermally coupled to the one or more semiconductor chips.

To minimize the length of the heat transfer path and reduce thermal resistance, one or more heatsinks are thermally coupled to the one or more semiconductor chips. Thermal resistance may be a measure of how effectively a material or interface resists the flow of heat. In other words, it is the ratio of the temperature difference required to transfer a certain amount of heat through a component, such as a heatsink. Lower thermal resistance may indicate better heat transfer efficiency of the heatsink. The power semiconductor device may comprise at least one power semiconductor chip and one heatsink, configured to provide a one-sided heat transfer path, wherein the at least one semiconductor chip may be thermally coupled to the one heatsink. The heat transfer path may comprise a route or sequence through which heat generated by the one or more power semiconductor chips is transferred through the heatsink into the surrounding environment of the body. The one-sided heat transfer path may comprise a route or sequence through which heat generated from only one side of the one or more power semiconductor chips is transferred through the heatsink into the surrounding environment of the body.

In an example, the power semiconductor device may comprise two or more semiconductor chips and the one or more heatsinks is thermally coupled to the two or more semiconductor chips.

The power semiconductor device may comprise at least two power semiconductor chips and one heatsink, configured to provide a one-sided heat transfer path, wherein the at least two power semiconductor chips may be coupled to the one heatsink. The power semiconductor device may comprise at least two power semiconductor chips and two heatsinks wherein the at least two power semiconductor chips may be coupled to the two heatsinks. The two heatsinks may be arranged adjacent to one another. They configured to provide a one-sided heat transfer path. The one-sided heat transfer path may comprise one route or sequence through which heat generated from one side of the two or more semiconductor chips is transferred through the two adjacent heatsinks into the surrounding environment of the bodies of the two heatsinks.

In an example, the power semiconductor device may comprise two heatsinks thermally coupled to opposite sides of the one or more semiconductor chips.

The power semiconductor device may comprise one or more power semiconductor chips and two heatsinks. The two heatsinks may be thermally coupled to opposite sides of the one or more semiconductor chips, configured to provide a double-sided heat transfer path. Thermally coupled to opposite sides of the one or more power semiconductor chips may mean that one of the heatsinks is thermally coupled to one side of the one or more power semiconductor chips and another heatsink is thermally coupled to the other side of the one or more power semiconductor chips. The two heatsinks may be arranged in opposite directions to one another or in such a way that a direction along height of the fins of one heatsink is transverse to a direction along height of the fins of the other heatsink. The double-sided heat transfer path may comprise two routes or sequences through which heat generated from two sides of the two semiconductor chips is transferred through the two heatsinks into the surrounding environment of the bodies of the two heatsinks. The two routes or sequences of the double-sided heat transfer path may be parallel. Thus, more cooling capacity for cooling the one or more semiconductor chips may be provided by using the two heatsinks thermally coupled to opposite sides of the one or more semiconductor chips.

In an example, the power semiconductor device may comprise a thermally conductive spacer arranged between one of the two heatsinks and a side of the one or more semiconductor chips.

The spacer may be a component used to create a controlled gap or distance between one of the two heatsinks and a side of the one or more semiconductor chips. The spacer may be made of a thermally conductive material like but not limited to aluminum or copper. The spacer may be used in the double-sided heat transfer path for heat exchange between one side of the one or more semiconductor chips and one of the heatsinks. The spacer may be used as an electrical insulator or a thermal interface between one side of the one or more power semiconductor chips and one of two heatsinks. Thus, more cooling capacity for cooling the one or more semiconductor chips may be provided by using the thermally conductive spacer between the two heatsinks.

In an example, the power semiconductor device may comprise a first substrate layer and a second substrate layer, the first substrate layer being electrically non-conductive, the second substrate layer being electrically conductive and configured to electrically connect an electrical terminal to the one or more semiconductor chips, the first substrate layer being arranged in between the base portion and the second substrate layer.

The power semiconductor device may comprise a substrate layers portion comprising the first substrate layer and the second substrate layer. The first substrate layer may be arranged in between the base portion and the second substrate layer. The second substrate layer may comprise at least a first terminal of the one or more semiconductor chips. The second substrate layer may be used for electrical pathways to the one or more power semiconductor chips. The first substrate layer may be used to isolate the electrical pathways from the base portion. Accordingly, the risk of electrical interference and overheating may be reduced. Furthermore, this configuration optimizes both the electrical performance and the thermal stability of the power semiconductor device. By optimizing a height of the first substrate layer, more cooling capacity for cooling the one or more semiconductor chips may be achieved.

In an example, the first substrate layer may be directly arranged on the base portion and the second substrate layer is directly arranged on the first substrate layer.

The surface of the base portion may be at least partially covered by the first substrate layer. The first substrate layer may be integrated with the base portion of the heatsink. The second substrate layer may be integrated with the first substrate layer. There may be no need for additional layers, such as sinter or thermal interface material, TIM, between the one or more power semiconductor chips and the base portion of the heatsink. Furthermore, using the two substrate layers may reduce the length of the heat transfer path between the one and more semiconductor chips and heatsink and may result in a smaller thermal resistance. Thus, the present invention may enhance the thermal performance of the heat transfer between the one or more power semiconductor chips and the heatsink.

In an example, the power semiconductor device may further comprise a third substrate layer and a fourth substrate layer, the third substrate layer being electrically non-conductive, the fourth substrate layer being electrically conductive and configured to electrically connect a further electrical terminal to another semiconductor chip than the semiconductor chip that the second substrate layer is connected to, the third substrate layer being arranged in between the second substrate layer and the fourth substrate layer.

The substrate layers portion may further comprise the third substrate layer and fourth substrate layer. The fourth substrate layer comprises at least a second terminal of the one or more semiconductor chips. By adding the third and fourth substrate layers in this configuration, multiple semiconductor chips may be connected to electrical terminals, each with its own dedicated electrical connection. The third substrate layer's properties may provide necessary insulation, preventing electrical interference between the second and fourth substrate layers. Meanwhile, the fourth substrate layer may enable electrical connectivity to a different semiconductor chip. This layered approach may not only improve electrical reliability but also may contribute to better thermal management and device stability.

According to a third aspect, there may be provided an electric vehicle comprising an electric motor, a power source, and an inverter system electrically connecting the electric motor with the power source, the inverter system comprising the power semiconductor device of the second aspect.

In particular, the vehicle may comprise two or more power semiconductor devices of the second aspect. The vehicle may comprise two or more power semiconductor devices of the second aspect and one or more heatsinks of the first aspect.

These and other aspects of the present disclosure will become apparent from and elucidated with reference to the examples described hereinafter.

### BRIEF DESCRIPTION OF DRAWINGS

Examples of the disclosure will be described in the following with reference to the following drawings.
- Figure 1: shows a cross-sectional view of an example of a power semiconductor device;
- Figure 2: shows a cross-sectional view of another example of a power semiconductor device; and
- Figure 3: shows a schematic illustration of an electric vehicle.

### DETAILED DESCRIPTION

The Figures are merely schematic representations and serve only to illustrate examples of the disclosure. Identical or equivalent elements are in principle provided with the same reference signs.

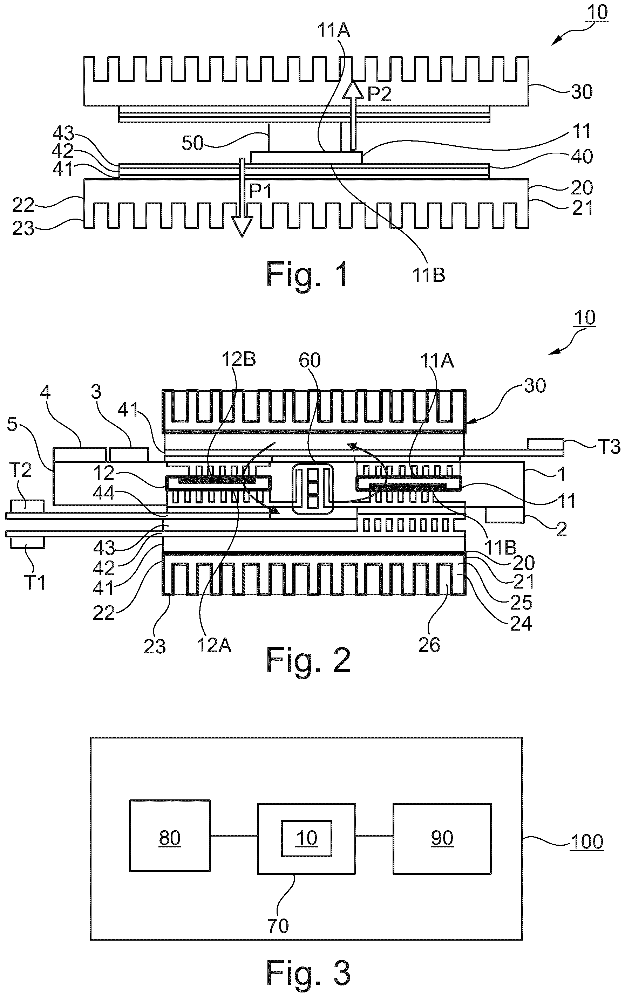

Figure 1 shows a power semiconductor device 10 for an inverter system 70 of an electric vehicle 100 (see Fig. 3). The power semiconductor device 10 comprises one semiconductor chip 11, a first heatsink 20 and a second heatsink 30, wherein the first heatsink 20 and the second heatsink 30 are thermally coupled to the semiconductor chip 11. In particular, the first heatsink 20 and the second heatsink 30 are thermally coupled to opposite sides of the semiconductor chip 11. A second side 11B of the first power semiconductor chip 11 is arranged opposite or at the first heatsink 20. Thus, the first heatsink 20 absorbs the heat from the power semiconductor chip 11, particularly through the second side 11B, creating a heat transfer path P1. Another side, namely first side 11A, of the first power semiconductor chip 11 is thermally coupled to or arranged opposite the second heatsink 30 through a spacer 50. Accordingly, the second heatsink 30 may also absorb the heat from the power semiconductor chip 11, creating a heat transfer path P2.

Additionally, the power semiconductor device 10 comprises a substrate layers portion 40 arranged between the first heatsink 20 and the second side 11B of the first power semiconductor chip 11, and between the second heatsink 30 and the first side 11A of the first power semiconductor chip 11. The spacer 50 is arranged between the substrate layers portion 40 and the first side 11A of the first power semiconductor chip 11. The substrate layers portion 40 is arranged between the heatsinks 20, 30 and the power semiconductor chip 11. The substrate layers portion 40 comprises a first substrate layer 41, a second substrate layer 42 and a third substrate layer 43, wherein the first substrate layer 41 and the third substrate layer 43 are electrically non-conductive and the second substrate layer 42 is electrically conductive. The first substrate layer 41 is arranged in between the base portion 21 and the second substrate layer 42, wherein the first substrate layer 41 is directly arranged on the base portion 21. The second substrate layer 42 is arranged in between the first substrate layer 41 and the third substrate layer 43, wherein the second substrate layer 42 is directly arranged on the first substrate layer 41. The third substrate layer 43 is arranged in between the second substrate layer 42 and the power semiconductor chip 11, wherein the third substrate layer 43 is directly arranged on the second substrate layer 42. The third substrate layer 43 is connected directly to the second side 11B of the first power semiconductor chip 11. The second heatsink 30 and the substrate layers portion 40 have a similar configuration. The only difference is that the third substrate layer 43 is connected directly to the spacer 50.

Figure 2 shows another example of a power semiconductor device 10. The power semiconductor device 10 comprises a first power semiconductor chip 11, a second power semiconductor chip 12, a first heatsink 20, a second heatsink 30, and a capacitor 60. The two semiconductor chips 11, 12 may be arranged such that the first side 11A of the first semiconductor chip 11 is opposite of a functionally corresponding first side 12A of the second semiconductor chip 12 and similarly for the second sides 11B, 12B. Functionally corresponding may mean that the respective sides 11A and 12A as well as 11B and 12B have the same function in their semiconductor chips 11, 12. For example, the first sides 11A, 12A may be drain sides and the second sides 11B, 12B may be source sides, or the other way around.

The capacitor 60 is arranged between the first semiconductor chip 11 and the second power semiconductor chip 12. The capacitor 60 is electrically connected to the first semiconductor chip 11 and the second power semiconductor chip 12. Both heatsinks 20, 30 comprise one or more interior channels 24 for cooling the heatsinks 20, 30, wherein the one or more interior channels 24 extend inside the body 21. These channels 24 inside the bodies 21 of the heatsinks 20, 30 are at least partially filled with a PCM 25. A fluid medium 26 surrounds the heatsinks 20, 30, particularly the fin portion 23. On the one hand, the fluid medium 26 may be naturally or actively conveyed to the fin portion 23 and in between the fins thereof for naturally or actively convection cooling of the heatsinks 20, 30 and thereby the power semiconductor chips 11, 12. On the other hand, the channels filled with PCM 25 may be used to additionally cool the power semiconductor chips 11, 12, specifically during peak loads of the power semiconductor device 10. Alternatively, or additionally, an actively cooled cooling fluid may be flowing through the channels 24 for actively cooling the power semiconductor chips 11, 12.

In this example, the second substrate layer 42 is connected to the first semiconductor chip 11. Particularly, the second substrate layer 42 is connected to the second side 11B of the first power semiconductor chip 11. The second substrate layer 42 is further configured to electrically connect a first electrical terminal T1 to the first semiconductor chip 11, wherein the first electrical terminal T1 is an input terminal of the power semiconductor device 10. The substrate layers portion 40 between the first heatsink 20 and the power semiconductor chips 11, 12 comprises an additional fourth substrate layer 44, which is electrically conductive. The fourth substrate layer 44 is arranged in between the third substrate layer 43 and the second power semiconductor chip 12. The fourth substrate layer 44 is connected to the second semiconductor chip 12. Particularly, the fourth substrate layer 44 is connected to the first side 12A of the second power semiconductor chip 12. The fourth substrate layer 44 is further configured to electrically connect a second electrical terminal T2 to the second semiconductor chip 12, wherein the second electrical terminal T2 is an input terminal of the power semiconductor device 10.

Similar to Fig. 1, the second substrate layer 42 is arranged in between the second heatsink 30 and the power semiconductor chips 11, 12, and connected to the first power semiconductor chip 11 and to the second power semiconductor chip 12. In particular, the second substrate layer 42 is connected to the second side 12B of the second power semiconductor chip 12 and to the first side 11A of the first power semiconductor chip 11. Said second substrate layer 42 is further configured to electrically connect a third electrical terminal T3 to the first semiconductor chip 11 and to the second power semiconductor chip 12, wherein the third electrical terminal T3 is an output terminal of the power semiconductor device 10.

In an example, the first and second terminals T1, T2 of the power semiconductor device 10 are DC input terminals and the third terminal is an AC output terminal of the inverter system 70 of the vehicle 100 shown in Fig. 3. The power semiconductor device 10 may further comprise a first integrated circuit 2, a second integrated circuit 3 for gate connections and a control of pulse width modulation 4, PWM, arranged on a common printed circuit board 1, PCB. The PCB 1 of the power semiconductor device 10 may comprise a connection socket 5 (indicated but not shown) to connect the power semiconductor device 10 to other power semiconductor devices.

Figure 3 shows an electric vehicle 100 comprising an electric motor 90, an inverter system 70, a power source 80 and a power semiconductor device 10. The electric motor 90 is electrically connected to the power source 80 via the inverter system 70. Specifically, the inverter system 70 may be converting a DC current supplied by the power source 80 to an AC current supplied to the electric motor 90 for propulsion of the electric vehicle 100. The power semiconductor device 10 comprises at least one heatsink 20as described herein.

As used herein, the phrase "at least one," in reference to a list of one or more entities should be understood to mean at least one entity selected from any one or more of the entities in the list of entities, but not necessarily including at least one of each and every entity specifically listed within the list of entities and not excluding any combinations of entities in the list of entities. This definition also allows that entities may optionally be present other than the entities specifically identified within the list of entities to which the phrase "at least one" refers, whether related or unrelated to those entities specifically identified. Thus, as a nonlimiting example, "at least one of A and B" (or, equivalently, "at least one of A or B," or, equivalently "at least one of A and/or B") may refer, in one example, to at least one, optionally including more than one, A, with no B present (and optionally including entities other than B); in another example, to at least one, optionally including more than one, B, with no A present (and optionally including entities other than A); in yet another example, to at least one, optionally including more than one, A, and at least one, optionally including more than one, B (and optionally including other entities). In other words, the phrases "at least one," "one or more," and "and/or" are open-ended expressions that are both conjunctive and disjunctive in operation. For example, each of the expressions "at least one of A, B, and C," "at least one of A, B, or C," "one or more of A, B, and C," "one or more of A, B, or C," and "A, B, and/or C" may mean A alone, B alone, C alone, A and B together, A and C together, B and C together, A, B, and C together, and optionally any of the above in combination with at least one other entity.

Other variations to the disclosed examples can be understood and effected by those skilled in the art in practicing the claimed disclosure, from the study of the drawings, the disclosure, and the appended claims. In the claims the word "comprising" does not exclude other elements or steps and the indefinite article "a" or "an" does not exclude a plurality. The mere fact that certain measures are recited in mutually different dependent claims does not indicate that a combination of these measures cannot be used to advantage. Any reference signs in the claims should not be construed as limiting the scope of the claims.

### LIST OF REFERENCE SIGNS

- 1: printed circuit board
- 2: first integrated circuit
- 3: second integrated circuit
- 4: control of pulse width modulation
- 5: socket
- 10: power semiconductor device
- 11: first power semiconductor chip
- 11A: first side of the first power semiconductor chip
- 11B: second side of the first power semiconductor chip
- 12: second power semiconductor chip
- 12A: first side of the second power semiconductor chip
- 12B: second side of the second power semiconductor chip
- 20: first heatsink
- 21: body
- 22: base portion
- 23: fin portion
- 24: interior channel
- 25: phase change material
- 26: fluid medium
- 30: second heatsink
- 40: substrate layers portion
- 41: first substrate layer
- 42: second substrate layer
- 43: third substrate layer
- 44: fourth substrate layer
- 50: spacer
- 60: capacitor
- 70: inverter system
- 80: power source
- 90: electric motor
- 100: electric vehicle
- P1: first cooling path
- P2: second cooling path
- T1: first terminal
- T2: second terminal
- T3: third terminal

## Claims

1. A heatsink (20) for a power semiconductor device (10) of an inverter system (70) of an electric vehicle (100), the heatsink (20) comprising a body (21) for heat exchange with one or more semiconductor chips (11) of the power semiconductor device (10), the body (21) comprising a base portion (22) for attachment to the power semiconductor device (10) and a fin portion (23) adjacent to the base portion (22), the fin portion (23) comprising a plurality of fins extended from the base portion (22), and the heatsink (20) comprising one or more interior channels (24) for cooling the heatsink (20), the one or more interior channels (24) extending inside the body (21).

2. The heatsink (20) of claim 1, wherein the one or more interior channels (24) are at least partially filled with a phase change material (25).

3. The heatsink (20) of claim 1 or 2, wherein the body (21) comprises an inlet and an outlet, the inlet and outlet being fluidically coupled to the one or more interior channels (24) for passing a cooling fluid through the one or more interior channels (24).

4. The heatsink (20) of any one of the previous claims, wherein at least one of the one or more interior channels (24) extends inside the plurality of fins.

5. The heatsink (20) of claim 4, wherein the at least one interior channel (24) extends in a meandering shape between adjacent fins of the plurality of fins.

6. The heatsink (20) of any one of the previous claims, wherein at least one of the one or more interior channels (24) extends inside the base portion (22).

7. The heatsink (20) of any one of the previous claims, wherein adjacent fins of the plurality of fins are spaced apart from one another in a direction transverse to their extension for convection cooling of the body (21).

8. A power semiconductor device (10) for an inverter system (70) of an electric vehicle (100), the power semiconductor device (10) comprising one or more semiconductor chips (11) and one or more heatsinks (20) of any one of the previous claims, wherein the one or more heatsink (20) is thermally coupled to the one or more semiconductor chip (11).

9. The power semiconductor device (10) of claim 8, wherein the power semiconductor device (10) comprises two or more semiconductor chips (11) and the one or more heatsink (20) is thermally coupled to the two or more semiconductor chips (11).

10. The power semiconductor device (10) of claim 8 or 9, wherein the power semiconductor device (10) comprises two heatsinks (20, 30) thermally coupled to opposite sides of the one or more semiconductor chip (11).

11. The power semiconductor device (10) of claim 10, wherein the power semiconductor device (10) comprises a thermally conductive spacer (59) arranged between one of the two heatsinks (20, 30) and a side of the one or more semiconductor chips (11).

12. The power semiconductor device (10) of any one of claims 8 to 11, wherein the power semiconductor device (10) comprises a first substrate layer (41) and a second substrate layer (42), the first substrate layer (41) being electrically non-conductive, the second substrate layer (42) being electrically conductive and configured to electrically connect an electrical terminal (T1) to the one or more semiconductor chip (11), the first substrate layer (41) being arranged in between the base portion (22) and the second substrate layer (42).

13. The power semiconductor device (10) of claim 12, wherein the first substrate layer (41) is directly arranged on the base portion (22) and the second substrate layer (42) is directly arranged on the first substrate layer (41).

14. The power semiconductor device (10) of claim 12 or 13, wherein the power semiconductor device (10) further comprises a third substrate layer (43) and a fourth substrate layer (44), the third substrate layer (43) being electrically non-conductive, the fourth substrate layer (44) being electrically conductive and configured to electrically connect a further electrical terminal (T2) to another semiconductor chip (12) than the semiconductor chip (11) that the second substrate layer (42) is connected to, the third substrate layer (43) being arranged in between the second substrate layer (42) and the fourth substrate layer (44).

15. An electric vehicle (100) comprising an electric motor (90), a power source (90), and an inverter system (70) electrically connecting the electric motor (90) with the power source (80), the inverter system (70) comprising the power semiconductor device (10) of any one of claims 8 to 14.
